# EUROPEAN PATENT APPLICATION

(11) **EP 4 671 409 A1**
(43) Date of publication of application: **31.12.2025**
(21) Application number: 24770555.1
(22) Date of filing: 29.02.2024
(51) Int. Cl.: C23C 14/34, C22C 21/00, C22C 28/00, C22C 30/00, C23C 14/06, H01L 21/203

(54) **AL-SC-GA SPUTTERING TARGET, AND METHOD FOR PRODUCING SAME**

(30) Priority: 14.03.2023 JP 2023039496
(71) Applicant: Tosoh Corporation, Yamaguchi 746-8501 (JP)
(72) Inventor: UEOKA, Yoshihiro, Ayase-shi, Kanagawa 252-1123 (JP); HARA, Hiroyuki, Ayase-shi, Kanagawa 252-1123 (JP); MESUDA, Masami, Ayase-shi, Kanagawa 252-1123 (JP); SHONO, Daiki, Ayase-shi, Kanagawa 252-1123 (JP)
(74) Representative: Novagraaf International SA
(86) International application number: PCT/JP2024/007609
(87) International publication number: WO 2024/190444

(57) **Abstract**

An Al-Sc-Ga sputtering target includes a main body portion that contains Al, Sc, and Ga and that does not contain a Ga phase. In the main body portion, the atomic ratio of Sc to Ga (Sc/Ga) may be 0.5 or more. In the main body portion, the atomic ratio of Sc to Ga (Sc/Ga) may be 20 or less. The Al-Sc-Ga sputtering target may further include a backing plate bonded to the main body portion with a bonding material interposed therebetween.

## Description

### Technical Field

The present disclosure relates to an Al-Sc-Ga sputtering target and a method for producing the same.

### Background Art

In recent years, there has been a growing interest in non-volatile ferroelectric memories. From the perspective of high ferroelectricity and reduced driving voltage, an aluminum scandium gallium nitride (hereinafter, referred to as "AlScGaN") film is expected to be suitable for ferroelectric memory applications (see Non Patent Literature 1).

Non Patent Literature 1 states that the AlScGaN film is formed by a ternary simultaneous reactive sputtering method with an Al target, a Sc target, and a GaN target.

However, as described in Non Patent Literature 1, when three types of targets are used, the power for each of the three types of targets must be controlled individually during sputtering, which complicates the control. Thus, it has been desired to use a single target, such as an Al-Sc-Ga sputtering target, for forming an AlScGaN film.

### Citation List

### Non Patent Literature

NPL 1: Reika Ota, et al., "Crystal Structure and Ferroelectricity of (Al1-x-yGaxScy)N Thin Films," [online], September 20, 2022, The Japan Society of Applied Physics Autumn Meeting, 20p-B103-10, [Accessed: February 10, 2023], Internet <URL: https://confit.atlas.jp/guide/event/jsap2022a/subject/20p-B103-10/tables?cryptoId=>

### Summary of Invention

### Technical Problem

However, for a sputtering target produced by bonding an Al-Sc-Ga alloy as a main body portion to a backing plate with a bonding material interposed therebetween, a failure occurred in which the main body portion was detached from the backing plate during sputtering.

It is an object of the present disclosure to provide at least one of an Al-Sc-Ga sputtering target that can inhibit the detachment of a main body portion and a method for producing the sputtering target.

### Solution to Problem

The inventors of the present disclosure investigated the cause of detachment of the main body portion. Upon visual observation of the surface of the main body portion, the inventors noticed that liquid metal exuded. The powder X-ray diffraction measurement of a section of the main body portion revealed an XRD peak corresponding to the (111) plane of metallic Ga at a diffraction angle of about 20 = 30.37°. The melting point of metallic Ga is 29.8°C. Thus, the inventors of the present disclosure considered that the detachment of the main body portion occurs as follows: During sputtering, metallic Ga in the Al-Sc-Ga alloy melts and exudes. The exuded molten metallic Ga then comes into contact with the bonding material, forming a low-melting-point alloy. As a result, the bonding material partially melts, leading to detachment. Thus, the inventors arrived at the present disclosure.

The scope of the present invention is defined by the claims. A summary of the present disclosure is provided below.
(1) An Al-Sc-Ga sputtering target comprising a main body portion containing Al, Sc, and Ga and not containing a Ga phase.
(2) In the Al-Sc-Ga sputtering target described in (1), the atomic ratio of Sc to Al (Sc/Al) in the main body portion is 0.25 or more.
(3) In the Al-Sc-Ga sputtering target described in (1) or (2), the atomic ratio of Sc to Ga (Sc/Ga) in the main body portion is 0.5 or more.
(4) In the Al-Sc-Ga sputtering target described in any one of (1) to (3), the atomic ratio of Sc to Ga (Sc/Ga) in the main body portion is 20 or less.
(5) The Al-Sc-Ga sputtering target described in any one of (1) to (4) further includes a backing plate bonded to the main body portion with a bonding material interposed therebetween.
(6) A method for producing an Al-Sc-Ga sputtering target includes a first step of producing a main body portion containing Al, Sc, and Ga in such a manner that the main body portion does not contain a Ga phase.
(7) In the method for producing an Al-Sc-Ga sputtering target described in (6), the main body portion is produced in the first step in such a manner that the atomic ratio of Sc to Al (Sc/Al) is 0.25 or more.
(8) In the method for producing an Al-Sc-Ga sputtering target described in (6) or (7), the main body portion is produced in the first step in such a manner that the atomic ratio of Sc to Ga (Sc/Ga) is 0.5 or more.
(9) In the method for producing an Al-Sc-Ga sputtering target described in any one of (6) to (8), the main body portion is produced in the first step in such a manner that the atomic ratio of Sc to Ga (Sc/Ga) is 20 or less.
(10) The method for producing an Al-Sc-Ga sputtering target described in any one of (6) to (9), further comprising a second step of bonding a backing plate to the main body portion with a bonding material interposed therebetween.

### Advantageous Effects of Invention

According to the present disclosure, at least one of the Al-Sc-Ga sputtering target and its production method is provided, in which the detachment of the main body portion can be inhibited.

### Brief Description of Drawings

[Fig. 1] Fig. 1 is a cross-sectional view illustrating an Al-Sc-Ga sputtering target according to an embodiment of the present disclosure.
[Fig. 2] Fig. 2 illustrates a SEM image and elemental mapping images of a sputtering target according to Example 1.
[Fig. 3] Fig. 3 illustrates a SEM image and elemental mapping images of a sputtering target according to Comparative Example 1.
[Fig. 4] Fig. 4 illustrates the results of a powder X-ray diffraction measurement according to Example 1.
[Fig. 5] Fig. 5 illustrates the results of a powder X-ray diffraction measurement according to Example 2.
[Fig. 6] Fig. 6 illustrates the results of a powder X-ray diffraction measurement according to Example 3.
[Fig. 7] Fig. 7 illustrates the results of a powder X-ray diffraction measurement according to Example 4.
[Fig. 8] Fig. 8 illustrates the results of a powder X-ray diffraction measurement according to Example 5.
[Fig. 9] Fig. 9 illustrates the results of a powder X-ray diffraction measurement according to Example 6.
[Fig. 10] Fig. 10 illustrates the results of a powder X-ray diffraction measurement according to Example 7.
[Fig. 11] Fig. 11 illustrates the results of a powder X-ray diffraction measurement according to Example 8.
[Fig. 12] Fig. 12 illustrates the results of a powder X-ray diffraction measurement according to Comparative Example 1.
[Fig. 13] Fig. 13 illustrates the results of a powder X-ray diffraction measurement according to Comparative Example 2.
[Fig. 14] Fig. 14 illustrates the results of the X-ray diffraction peak pattern measurement of an Al-Sc-Ga-N film obtained by using the sputtering target according to Example 6.

### Description of Embodiments

Embodiments of the present disclosure will be described in detail by way of example. However, the present disclosure is not limited to the following embodiments. The present disclosure includes any combination of configurations and parameters disclosed in this specification. The present disclosure also includes any range of combinations of the upper and lower limits of the values disclosed in this specification.

### <Al-Sc-Ga Sputtering Target>

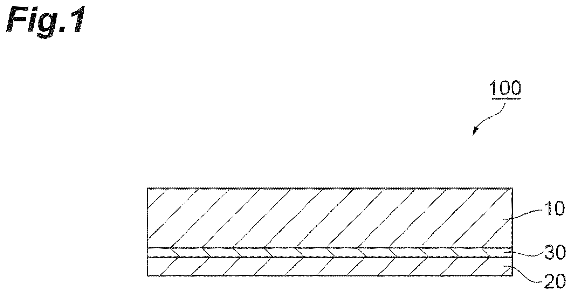

An embodiment of the Al-Sc-Ga sputtering target of the present disclosure will be described with reference to Fig. 1. Fig. 1 is a cross-sectional view illustrating an Al-Sc-Ga sputtering target according to an embodiment of the present disclosure.

As illustrated in Fig. 1, an Al-Sc-Ga sputtering target (hereinafter, also referred to simply as a "target") 100 includes a main body portion 10 that contains Al, Sc, and Ga and that does not contain a Ga phase.

The target 100 may further include a backing plate 20 bonded to the main body portion 10 with a bonding material 30 interposed therebetween.

According to the target 100, when the backing plate 20 is bonded to the main body portion 10 with the bonding material 30 interposed therebetween, even if the main body portion 10 is subjected to sputtering in that state to thereby increase the temperature of the main body portion 10, the melting and exudation of metallic Ga to the surface is inhibited, the formation of a low-melting-point alloy of the bonding material 30 and Ga is inhibited, and the detachment of the main body portion 10 from the backing plate 20 due to the melting and exudation of the low-melting-point metal is inhibited.

Even when the target 100 is placed in a sputtering apparatus with the main body portion 10 facing downward relative to the backing plate 20, liquid metal Ga is inhibited from falling, thereby inhibiting the adverse effects on the sputtering apparatus caused by the falling metal Ga.

Since the main body portion 10 does not contain a Ga phase, which has a melting point of 29.8°C, even if the main body portion 10 is heated, the Ga phase is inhibited from melting and exuding from the main body portion 10 as liquid metallic Ga. Thus, while the main body portion 10 of the target 100 is being subjected to sputtering, the plasma during sputtering is inhibited from becoming unstable due to the melting and exudation of metallic Ga to the surface of the main body portion 10. For this reason, when an AlScGaN film is formed by reactive sputtering with nitrogen supplied to the sputtering apparatus, a deterioration in the uniformity of the characteristics is inhibited.

The main body portion 10, the backing plate 20, and the bonding material 30 will be described in detail below.

### (Main Body Portion)

The main body portion 10 is composed of Al, Sc, and Ga and does not contain a Ga phase. The Ga phase is a phase composed of metallic Ga. The phrase "does not contain a Ga phase" indicates that when a powder X-ray diffraction (hereinafter, also referred to as "XRD") measurement is performed on a section of the main body portion 10 in the thickness direction under the following conditions, no XRD peak corresponding to the (111) plane of metallic Ga is observed at about 2θ = 30.37°. Here, "no XRD peak is observed" indicates that "the XRD peak intensity is 10% or less of the maximum peak intensity in the range of 2θ = 20° to 40°". The XRD measurement can be performed with, for example, a crystallinity-analysis X-ray diffractometer (product name: Ultima IV, manufactured by RIGAKU Corporation).

### <Conditions>

Acceleration current/voltage: 40 mA/40 kV
Radiation source: CuKα radiation
Measurement mode: continuous scan
Scanning condition: 2 °/minute
Measurement range: 2θ = 20° to 80°
Divergence vertical-limiting slit: 10 mm
Divergence/entrance slit: 1/2°
Receiving slit: 0.3 mm

The main body portion 10 may contain an alloy phase. Examples of the alloy phase include phases each composed of an alloy containing two or more metallic elements. Examples of such alloys include alloys of Sc and Al and alloys of Sc and Ga. Two or more of these alloys may be included. The main body portion 10 may also include at least one of an Al phase and a Sc phase.

In the main body portion 10, the Al content is not particularly limited, but is preferably 80% or less, more preferably 70% or less, based on the total number of Al, Sc, and Ga atoms (100%). In the case of an Al content of 80% or less based on the total number of Al, Sc, and Ga atoms (100%), when a thin film is formed by sputtering with the Al-Sc-Ga sputtering target of the present disclosure, the resulting thin film can exhibit high dielectric properties.

The Al content is preferably 20% or more, more preferably 30% or more, based on the total number of Al, Sc, and Ga atoms (100%).

Any combination of the upper limits and lower limits described above may be used.

In the main body portion 10, the Sc content is not particularly limited, but is preferably 30% or more, more preferably 40% or more, based on the total number of Al, Sc, and Ga atoms (100%). When the Sc atom content is 30% or more based on the total number of Al, Sc, and Ga atoms (100%), the target can be easily processed because the target does not contain a metallic Ga phase.

The Sc content is preferably 90% or less, more preferably 80% or less, based on the total number of Al, Sc, and Ga atoms (100%).

Any combination of the upper limits and lower limits described above may be used.

In the main body portion 10, the Ga content is not particularly limited, but is preferably 30% or less, more preferably 20% or less, based on the total number of Al, Sc, and Ga atoms (100%). When the Ga content is 30% or less, based on the total number of Al, Sc, and Ga atoms (100%), the target can be easily processed because the target does not contain a metallic Ga phase.

The Ga content is preferably 5% or more, more preferably 10% or more, based on the total number of Al, Sc, and Ga atoms (100%).

Any combination of the upper limits and lower limits described above may be used.

The sum of the Al content, the Sc content, and the Ga content is 100%.

In the main body portion 10, the atomic ratio of Sc to Ga (Sc/Ga) is not particularly limited as long as it is more than 0. However, the atomic ratio is, for example, more than 0.25, preferably 0.5 or more, more preferably 2 or more, and particularly preferably 4 or more. When Sc/Ga is 0.5 or more, the melting and exudation of metallic Ga from the target 100 is effectively inhibited.

Sc/Ga is preferably 20 or less, more preferably 10 or less, and particularly preferably 8 or less. When Sc/Ga is 20 or less, the main body portion 10 can be produced at low cost.

Any combination of the upper limits and lower limits described above may be used.

The atomic ratio of Sc to Al (Sc/Al) is not particularly limited as long as it is more than 0. However, the atomic ratio is preferably 0.25 or more, more preferably 0.5 or more. In the case of the Sc/Al ratio of 0.25 or more, when a thin film is formed by sputtering with the Al-Sc-Ga sputtering target of the present disclosure, the resulting thin film can exhibit high dielectric properties. Sc/Al is preferably 2 or less, more preferably 1.5 or less.

Any combination of the upper limits and lower limits described above may be used.

The thickness of the main body portion 10 is not particularly limited, but may be 30 mm or less, 20 mm or less, 15 mm or less, 10 mm or less, or 8 mm or less.

The thickness of the main body portion 10 may be 1 mm or more, 2 mm or more, 3 mm or more, or 5 mm or more.

Any combination of the upper limits and lower limits described above may be used.

### (Backing Plate)

The backing plate 20 is used to cool the main body portion 10 during sputtering of the main body portion 10. For example, the backing plate 20 is made of oxygen-free copper, titanium, stainless steel, or the like.

### (Bonding Material)

The bonding material 30 is not particularly limited as long as it is made of a material that can bond the main body portion 10 and the backing plate 20. From the viewpoint of inhibiting thermal diffusion and thermal expansion during sputtering, at least one of indium and tin (indium, tin, or an alloy of indium and tin) is preferably used.

### <Method for Producing Al-Sc-Ga Sputtering Target>

A method for producing an Al-Sc-Ga sputtering target of the present disclosure will be described below.

A method for producing an Al-Sc-Ga sputtering target of the present disclosure includes a step of producing the main body portion 10 that contains Al, Sc, and Ga and that does not contain a Ga phase (hereinafter, also referred to as a "first step"). The method for producing an Al-Sc-Ga sputtering target of the present disclosure may further include, after the first step, a second step of bonding the backing plate 20 to the main body portion 10 with the bonding material 30 interposed therebetween to provide the Al-Sc-Ga sputtering target 100. That is, the main body portion 10 obtained in the first step may be used as an Al-Sc-Ga sputtering target as it is. Alternatively, the backing plate 20 may be bonded to the main body portion 10 with the bonding material 30 interposed therebetween in the second step, and the resulting target may be used as the Al-Sc-Ga sputtering target 100.

According to the above-described method for producing an Al-Sc-Ga sputtering target, it is possible to produce the Al-Sc-Ga sputtering target 100 in which the detachment of the main body portion 10 can be inhibited.

The first step will be described in detail below.

Specifically, the main body portion 10 is obtained by melting a mixture of an Al raw material, a Sc raw material, and a Ga raw material to form a melt, and subjecting the melt to post-treatment as needed. In this case, the Ga raw material does not easily form an alloy with the Al raw material, but easily forms an alloy with the Sc raw material. Thus, the formation of a Ga phase is easily inhibited by adjusting the atomic ratio of Al, Sc, and Ga in the Al, Sc, and Ga raw materials in a wellbalanced manner. A method for melting the mixture of the Al raw material, the Sc raw material, and the Ga raw material is not particularly limited, and examples thereof include a melting method and an arc melting method. These methods allow for the easy preparation of the melt. An example of the post-treatment for the melt is a method in which the melt is converted into fine powder particles by a gas atomization technique and then the powder particles are sintered by any sintering method, such as hot pressing. This post-treatment method results in the main body portion 10 having fine crystal grains.

The mixture of the above raw materials is prepared in such a manner that Sc/Ga is, for example, more than 0.25, preferably 0.5 or more, more preferably 2 or more, and particularly preferably 4 or more. When Sc/Ga is 0.5 or more, the formation of the Ga phase is easily inhibited.

The mixture of the above raw materials is prepared in such a manner that Sc/Ga is preferably 20 or less, more preferably 10 or less, and particularly preferably 8 or less. When Sc/Ga is 20 or less, the main body portion 10 can be produced at low cost.

Any combination of the upper limits and lower limits described above may be used.

The mixture of the above raw materials is prepared in such a manner that the atomic ratio of Sc to Al (Sc/Al) is preferably 0.25 or more, more preferably 0.5. When Sc/Al is 0.25 or more, the Sc raw material easily forms an alloy with the Ga raw material, making it easier to prevent the formation of a Ga phase.

The mixture of the above raw materials is prepared in such a manner that Sc/Al is preferably 2 or less, more preferably 1.5 or less.

Any combination of the upper limits and lower limits described above may be used.

The form of each raw material is not particularly limited, and each raw material may be in the form of a powder, flakes, or ingots.

The mixture of the Al raw material, the Sc raw material, and the Ga raw material can be heated in a container, such as a crucible or a mold. The crucible and the mold may be made of any material that does not melt at the melting point of the Sc raw material, which has the highest melting point among the Al raw material, the Sc raw material, and the Ga raw material, and may be made of, for example, alumina, zirconia, or water-cooled copper.

The heating temperature of the raw materials may be any temperature that is higher than or equal to a temperature at which all of the Al raw material, the Sc raw material, and the Ga raw material melt. Of the Al raw material, the Sc raw material, and the Ga raw material, the raw material having the highest melting point is the Sc raw material, which has a melting point of 1,541°C. Thus, the heating temperature may be a temperature that is 1,541°C or higher.

The heating temperature of the raw materials is preferably 1,800°C or lower, more preferably 1,700°C or lower.

Any combination of the upper limits and lower limits described above may be used.

The heating time of the raw materials is not particularly limited, and may be 0.25 hours or more, 0.5 hours or more, 1 hour or more, or 3 hours or more.

In consideration of production efficiency, the heating time of the raw materials may be 10 hours or less, 8 hours or less, 6 hours or less, or 5 hours or less.

Any combination of the upper limits and lower limits described above may be used.

As post-processing, the solidified melt may be processed into a plate-like shape by, for example, grinding or cutting. Specific examples of the processing means include machining devices, such as a surface grinder, a cylindrical grinder, a lathe, a cutting machine, and a machining center.

### EXAMPLES

Hereinafter, the contents of the present disclosure will be described in more detail with reference to examples and comparative examples. However, the present disclosure is not limited to the Examples below.

### (Example 1)

An Al raw material, a Sc raw material, and a Ga raw material were provided. These raw materials were charged into an alumina crucible having an inside diameter of ø25 mm, an outside diameter of ø35 mm, and a height of 60 mm in such a manner that the atomic ratio of Al, Sc, and Ga was Al:Sc:Ga = 30:50:20. At this time, the Al raw material, the Sc raw material, and the Ga raw material were placed from the bottom of the crucible in order of decreasing melting point (that is, in order of Sc, Al, and Ga).

The crucible was then placed in a furnace. The mixture was melted by heating at 1,600°C for 0.5 hours under an Ar atmosphere, and the resulting melt was subsequently cooled to room temperature. In this manner, an Al-Sc-Ga sputtering target having a main body portion of an ingot, in which the atomic ratio of Al, Sc, and Ga was Al:Sc:Ga = 30:50:20, was obtained by the melting method.

### (Example 2)

An Al raw material, a Sc raw material, and a Ga raw material were provided. These raw materials were charged into an alumina crucible in such a manner that the atomic ratio of Al, Sc, and Ga was Al:Sc:Ga = 30:60:10. At this time, the Al raw material, the Sc raw material, and the Ga raw material were placed from the bottom of the crucible in order of decreasing melting point (that is, in order of Sc, Al, and Ga).

The crucible was then placed in a furnace. The mixture was melted by heating at 1,600°C for 0.5 hours under an Ar atmosphere, and the resulting melt was subsequently cooled to room temperature. In this manner, an Al-Sc-Ga sputtering target having a main body portion of an ingot, in which the atomic ratio of Al, Sc, and Ga was Al:Sc:Ga = 30:60:10, was obtained by the melting method.

### (Example 3)

An Al raw material, a Sc raw material, and a Ga raw material were provided. These raw materials were charged into an alumina crucible in such a manner that the atomic ratio of Al, Sc, and Ga was Al:Sc:Ga = 50:30:20. At this time, the Al raw material, the Sc raw material, and the Ga raw material were placed from the bottom of the crucible in order of decreasing melting point (that is, in order of Sc, Al, and Ga).

The crucible was then placed in a furnace. The mixture was melted by heating at 1,600°C for 0.5 hours under an Ar atmosphere, and the resulting melt was subsequently cooled to room temperature. In this manner, an Al-Sc-Ga sputtering target having an ingot as a main body portion, in which the atomic ratio of Al, Sc, and Ga was Al:Sc:Ga = 50:30:20, was obtained by the melting method.

### (Example 4)

An Al raw material, a Sc raw material, and a Ga raw material were provided. These raw materials were charged into an alumina crucible having an inside diameter of ø25 mm, an outside diameter of ø35 mm, and a height of 60 mm in such a manner that the atomic ratio of Al, Sc, and Ga was Al:Sc:Ga = 30:30:40. At this time, the Al raw material, the Sc raw material, and the Ga raw material were placed from the bottom of the crucible in order of decreasing melting point (that is, in order of Sc, Al, and Ga).

The crucible was then placed in a furnace. The mixture was melted by heating at 1,600°C for 0.5 hours under an Ar atmosphere, and the resulting melt was subsequently cooled to room temperature. In this manner, an Al-Sc-Ga sputtering target having a main body portion of an ingot, in which the atomic ratio of Al, Sc, and Ga was Al:Sc:Ga = 30:30:40, was obtained by the melting method.

### (Example 5)

An Al raw material, a Sc raw material, and a Ga raw material were provided. These raw materials were charged into a water-cooled copper mold having a diameter of ø35 mm and a height of 10 mm in such a manner that the atomic ratio of Al, Sc, and Ga was Al:Sc:Ga = 30:30:40. At this time, the Al raw material, the Sc raw material, and the Ga raw material were placed from the bottom of the mold in order of decreasing melting point (that is, in order of Sc, Al, and Ga).

The raw materials in the mold were melted by heating in an arc melting furnace under an Ar atmosphere at 100 A for 5 minutes, and then the resulting melt was cooled to room temperature. In this manner, an Al-Sc-Ga sputtering target having a main body portion of an ingot, in which the atomic ratio of Al, Sc, and Ga was Al:Sc:Ga = 30:30:40, was obtained by the arc melting method.

### (Example 6)

An Al raw material, a Sc raw material, and a Ga raw material were provided. These raw materials were charged into a water-cooled copper mold having a diameter of ø65 mm and a height of 12 mm in such a manner that the atomic ratio of Al, Sc, and Ga was Al:Sc:Ga = 40:50: 10. At this time, the Al raw material, the Sc raw material, and the Ga raw material were placed from the bottom of the mold in order of decreasing melting point (that is, in order of Sc, Al, and Ga).

The raw materials in the mold were melted by heating in an arc melting furnace under an Ar atmosphere at 100 A for 5 minutes, and then the resulting melt was cooled to room temperature. In this manner, an Al-Sc-Ga sputtering target having a main body portion of an ingot, in which the atomic ratio of Al, Sc, and Ga was Al:Sc:Ga = 40:50:10, was obtained by the arc melting method.

### (Example 7)

An Al raw material, a Sc raw material, and a Ga raw material were provided. These raw materials were charged into a water-cooled copper mold having a diameter of ø35 mm and a height of 10 mm in such a manner that the atomic ratio of Al, Sc, and Ga was Al:Sc:Ga = 20:75:5. At this time, the Al raw material, the Sc raw material, and the Ga raw material were placed from the bottom of the mold in order of decreasing melting point (that is, in order of Sc, Al, and Ga).

The raw materials in the mold were melted by heating in an arc melting furnace under an Ar atmosphere at 100 A for 5 minutes, and then the resulting melt was cooled to room temperature. In this manner, an Al-Sc-Ga sputtering target having a main body portion, in which the atomic ratio of Al, Sc, and Ga was Al:Sc:Ga = 20:75:5, was obtained by the arc melting method.

### (Example 8)

An Al raw material, a Sc raw material, and a Ga raw material were provided. These raw materials were weighed and charged into a water-cooled copper mold having a diameter of ø35 mm and a height of 10 mm in such a manner that the atomic ratio of Al, Sc, and Ga was Al:Sc:Ga = 40:50:10. At this time, the Al raw material, the Sc raw material, and the Ga raw material were placed from the bottom of the mold in order of decreasing melting point (that is, in order of Sc, Al, and Ga).

The raw materials in the mold were then melted by an arc melting method. Specifically, the raw materials in the mold were melted by heating in an arc melting furnace under an Ar atmosphere at 100 A for 5 minutes. In this manner, an ingot was produced in which the atomic ratio of Al, Sc, and Ga was Al:Sc:Ga = 40:50:10. The ingot was placed in an alumina crucible for gas atomization, and powder was produced under the following gas atomization conditions. In this manner, a powder in which Al:Sc:Ga = 40:50:10 was obtained by a gas atomization method.

### <Gas Atomization Conditions>

Temperature: 1,400°C
Gas: Ar
Gas pressure: 3 MPa

The powder was fired by a hot-pressing method under the following conditions, providing an Al-Sc-Ga sputtering target having a main body portion made of a sintered body in which Al:Sc:Ga =40:50:10.

### <Conditions>

Temperature: 1,050°C
Holding time: 3 hours
Atmosphere: vacuum
Pressure: 20 MPa

### (Comparative Example 1)

An Al raw material and a Ga raw material were provided. These raw materials were charged into an alumina crucible in such a manner that the atomic ratio of Al to Ga was Al:Ga = 80:20. At this time, the Al raw material and the Ga raw material were placed from the bottom of the crucible in order of decreasing melting point (that is, in order of Al and Ga).

The crucible was then placed in a furnace. The mixture was melted by heating at 1,200°C for 0.5 hours under an Ar atmosphere. In this manner, an Al-Ga sputtering target having a main body portion of an ingot, in which the atomic ratio of Al to Ga was Al:Ga = 80:20, was obtained by the melting method.

### (Comparative Example 2)

An Al raw material, a Sc raw material, and a Ga raw material were provided. These raw materials were charged into an alumina crucible in such a manner that the atomic ratio of Al, Sc, and Ga was Al:Sc:Ga = 25:15:60. At this time, the Al raw material, the Sc raw material, and the Ga raw material were placed from the bottom of the crucible in order of decreasing melting point (that is, in order of Sc, Al, and Ga).

The crucible was then placed in a furnace. The mixture was melted by heating at 1,600°C for 0.5 hours under an Ar atmosphere. In this manner, an Al-Sc-Ga sputtering target having a main body portion of an ingot, in which the atomic ratio of Al, Sc, and Ga was Al:Sc:Ga = 25:15:60, was obtained by the melting method.

### <Determination of presence or absence of Ga phase>

For the cross section in the thickness direction of the main body portion of each of the sputtering targets of Examples 1 to 8 obtained as described above, powder X-ray diffraction (XRD) measurement was performed at room temperature (25°C or lower) under the following conditions. The XRD measurement was performed using a crystallinity-analysis X-ray diffractometer (product name: Ultima IV, manufactured by RIGAKU Corporation).

### <Conditions>

Acceleration current/voltage: 40 mA/40 kV
Radiation source: CuKα radiation
Measurement mode: continuous scan
Scanning condition: 2 °/minute
Measurement range: 20 = 20° to 80°
Divergence vertical-limiting slit: 10 mm
Divergence/entrance slit: 1/2°
Receiving slit: 0.3 mm

The main body portions of the sputtering targets of Comparative Examples 1 and 2 obtained as described above crumbled into powder upon cutting. Thus, the targets were subjected to XRD measurement in powder form, as in Example 1.

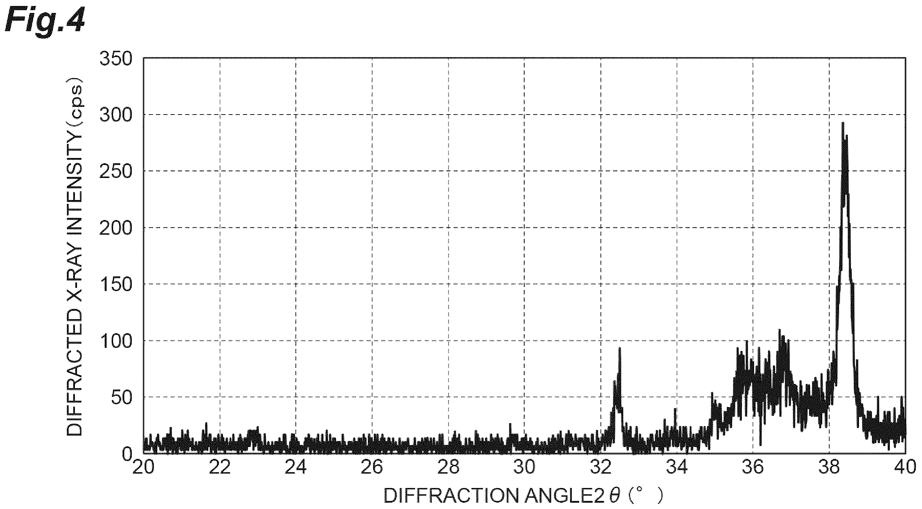

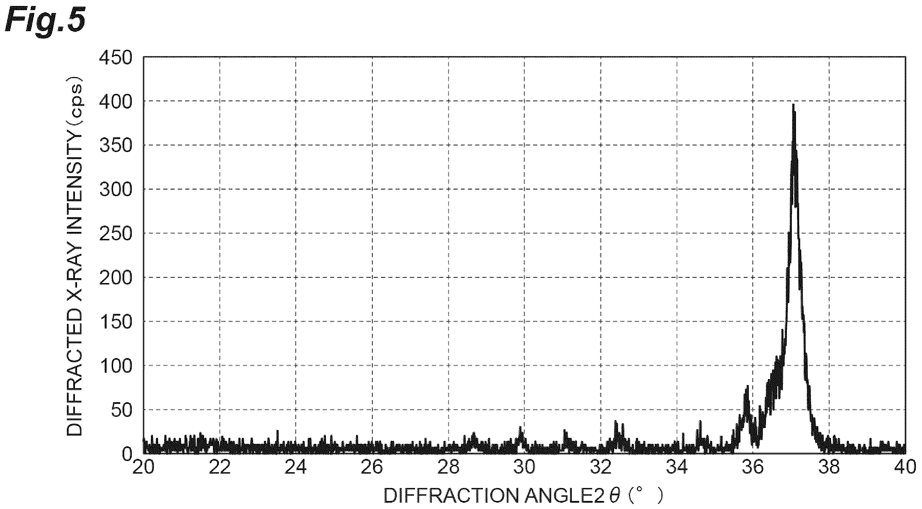

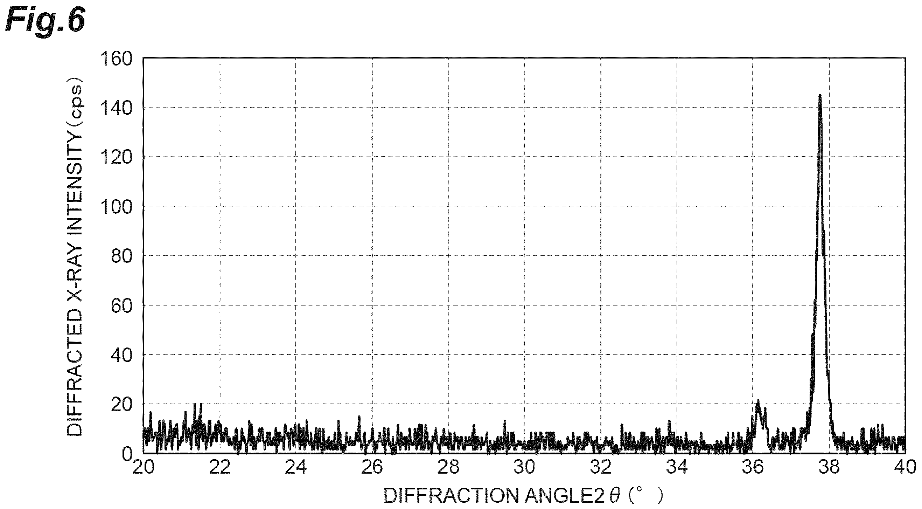

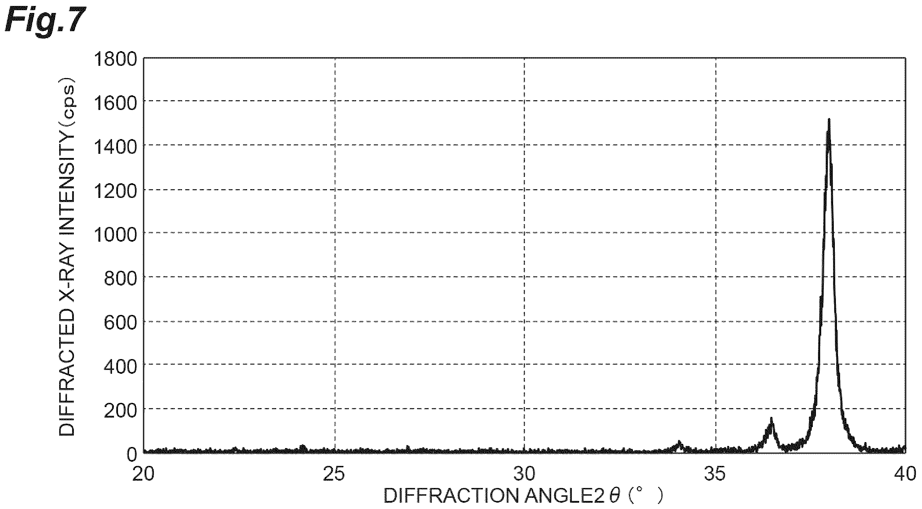

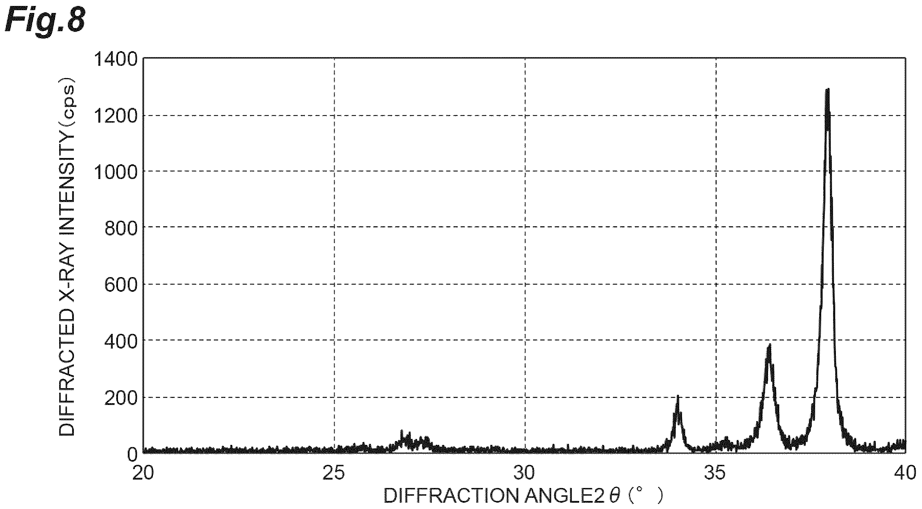

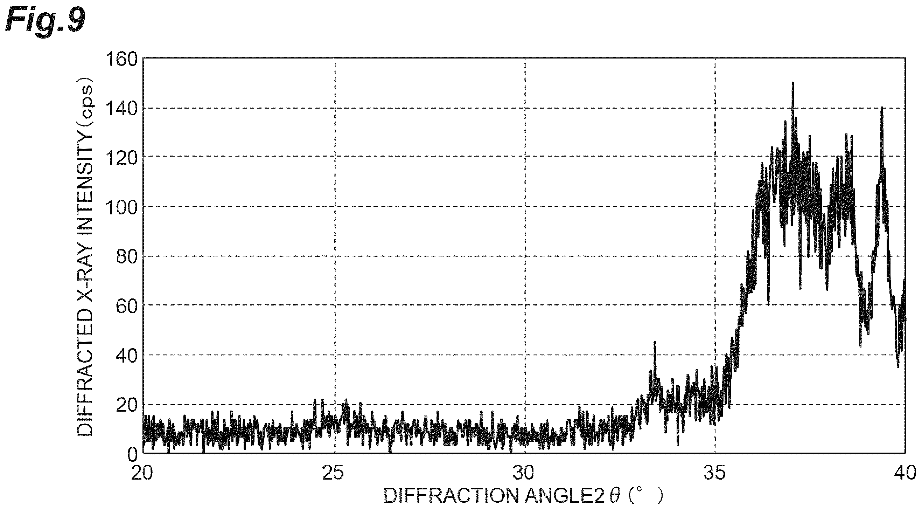

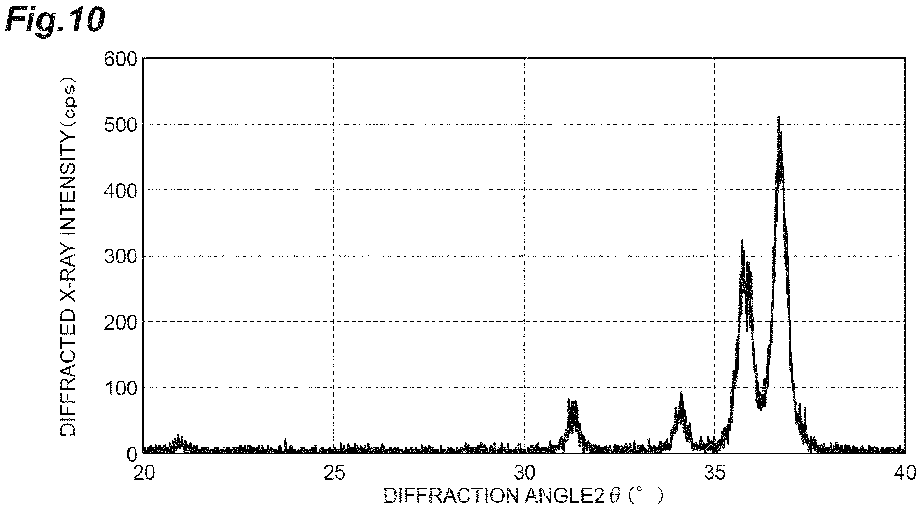

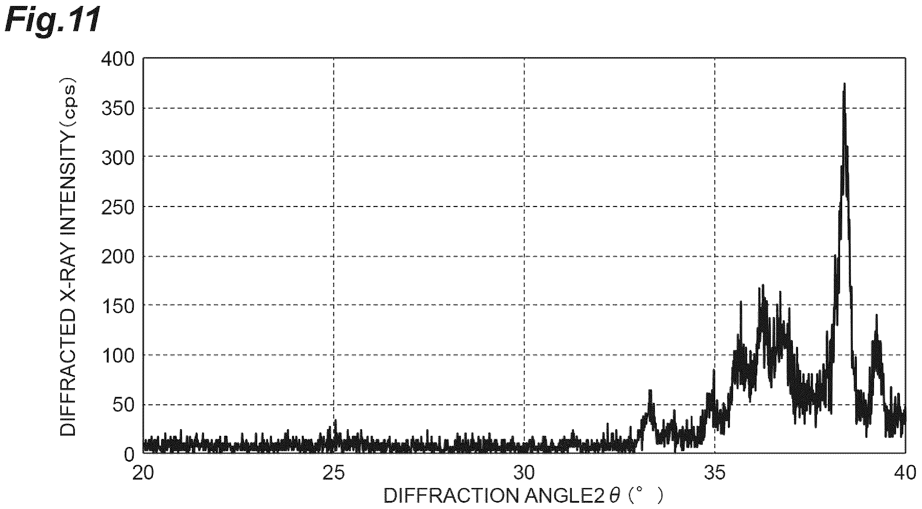

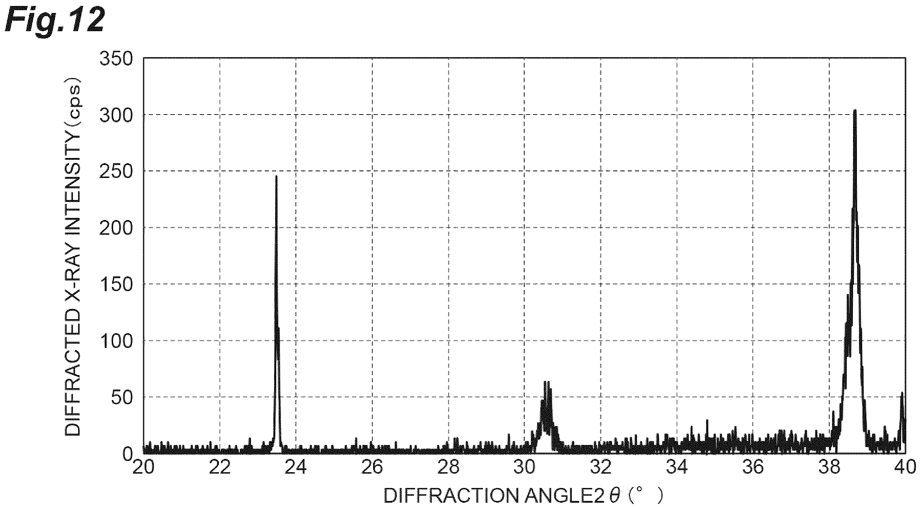

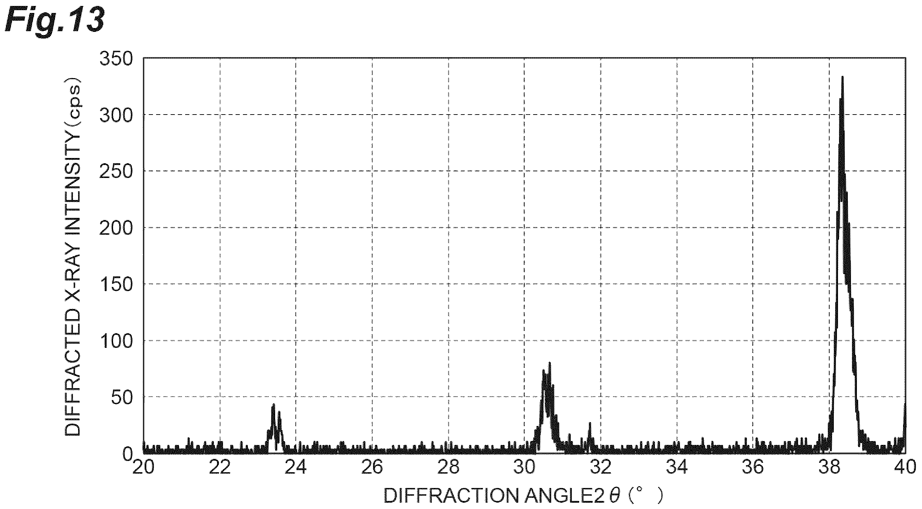

It was determined whether the main body portion of the sputtering target contained a Ga phase by identifying the presence or absence of the XRD peak corresponding to the (111) plane of metallic Ga, which appears at about 2θ = 30.37°, in the above-described measurement. The results are presented in Table 1. For Examples 1 to 8 and Comparative Examples 1 and 2, the results of XRD measurements are illustrated in Figs. 4 to 13. In Figs. 4 to 11, no XRD peak corresponding to the (111) plane of metallic Ga was observed at about 20 = 30.37°. In contrast, in each of Figs. 12 to 13, the XRD peak corresponding to the (111) plane of metallic Ga was observed at about 20 = 30.37°.

The sputtering targets of Examples 1 to 8 and Comparative Examples 1 and 2 obtained as described above were cut in the thickness direction. The resulting cross sections were mirror-polished and then observed using an EDS-equipped SEM (manufactured by JEOL Ltd., product name: "JSM-IT800") to acquire a mapping image of Ga elements.

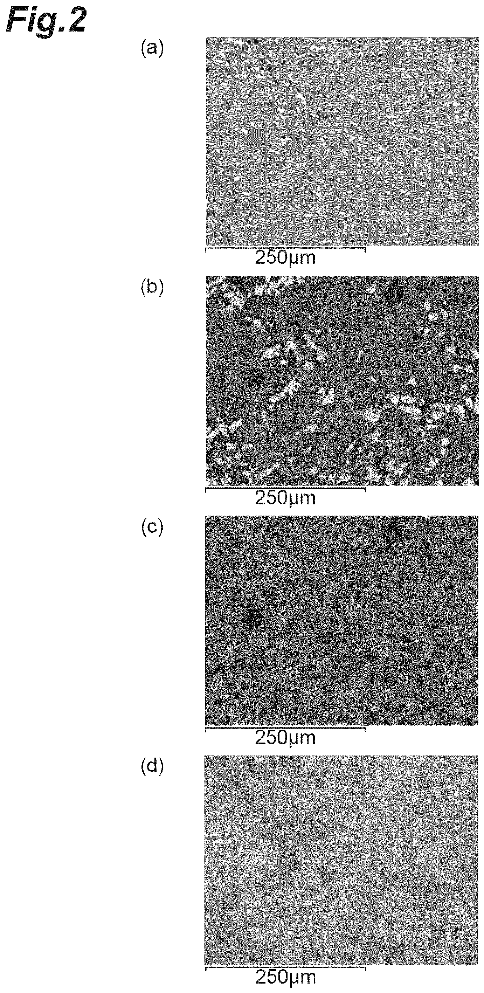

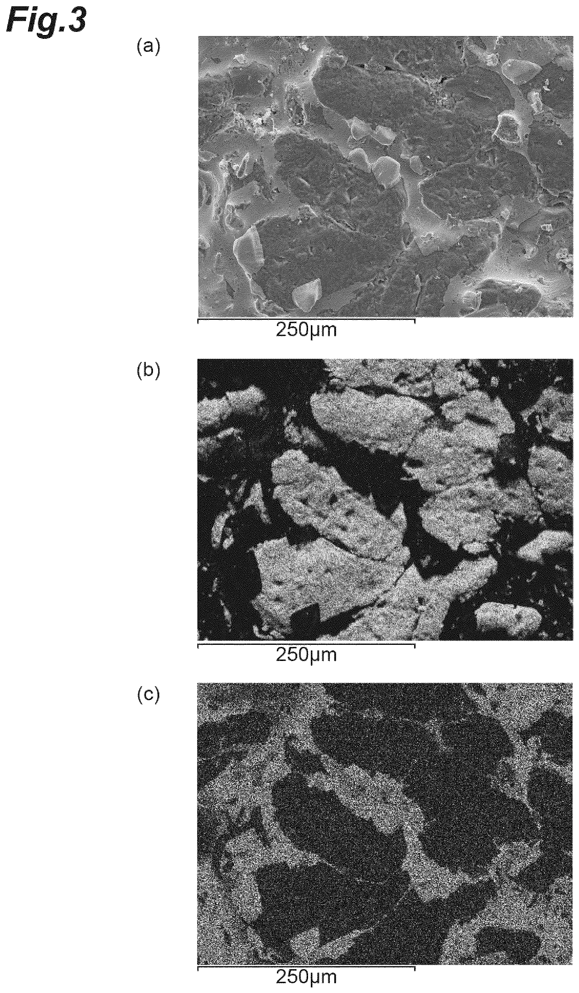

For Example 1 and Comparative Example 1, SEM images and elemental mapping images are illustrated in Figs. 2 and 3. In Fig. 2, (a) illustrates an SEM image, (b) illustrates an elemental mapping image of Al, (c) illustrates an elemental mapping image of Sc, and (d) illustrates an elemental mapping image of Ga. In Fig. 3, (a) illustrates an SEM image, (b) illustrates an elemental mapping image of Al, and (c) illustrates an elemental mapping image of Ga.

In (d) of Fig. 2, no gradation of color is observed, and the whole image is a dense (dark) image. This indicates that the Ga element is not segregated, that is, no Ga phase (single phase of the Ga element) is present.

In (c) of Fig. 3, there are gradations of color. The deep (dark) color portions indicate that the Ga element is not segregated, that is, no Ga phase is present. The light-colored portions indicate that the Ga element is segregated, that is, the Ga phase is present.

Therefore, it can be seen that in Example 1, the main body portion does not contain a Ga phase, whereas in Comparative Example 1, the main body portion contains a Ga phase.

### <Evaluation of Sputtering Target>

The sputtering targets of Examples 1 to 8 and Comparative Examples 1 and 2 were subjected to a metallic Ga melting and exudation test. Specifically, the sputtering target was held in a thermostatic chamber at 60°C for 3 hours, and the presence or absence of melting and exudation of metallic Ga was visually inspected. After being held, the target was removed from the thermostatic chamber. When no liquid metal melted or exuded at the location of the thermostatic chamber where the target was placed, the melting and exudation of metallic Ga was determined to be "absent". When the liquid metal melted and exuded, the melting and exudation of metallic Ga was determined to be "present" after cooling. The results are presented in Table 1. When the exuded liquid metal in each of Comparative Examples 1 and 2 was subjected to XRD measurement under the above conditions, the XRD peak corresponding to the (111) plane of metallic Ga was observed at about 2θ = 30.37°.

**[Table 1]**

| | Composition | | | Sc/Ga | Method for producing target | Presence or absence of Ga phase | Presence or absence of melting and exudation of metallic Ga |
|---|---|---|---|---|---|---|---|
| | Al | Sc | Ga | | | | |
| Example 1 | 30 | 50 | 20 | 2.5 | melting method | absent | absent |
| Example 2 | 30 | 60 | 10 | 6 | melting method | absent | absent |
| Example 3 | 50 | 30 | 20 | 1.5 | melting method | absent | absent |
| Example 4 | 30 | 30 | 40 | 0.75 | melting method | absent | absent |
| Example 5 | 30 | 30 | 40 | 0.75 | arc melting method | absent | absent |
| Example 6 | 40 | 50 | 10 | 5 | arc melting method | absent | absent |
| Example 7 | 20 | 75 | 5 | 15 | arc melting method | absent | absent |
| Example 8 | 40 | 50 | 10 | 5 | arc melting method + gas atomization method + hot-pressing method | absent | absent |
| Comparative Example 1 | 80 | - | 20 | - | melting method | present | present |
| Comparative Example 2 | 25 | 15 | 60 | 0.25 | melting method | present | present |

From the results presented in Table 1, in the sputtering targets of Examples 1 to 8, no melting or exudation of metallic Ga was observed. In contrast, in Comparative Examples 1 and 2, the Ga phase was "present".

The results revealed that according to the Al-Sc-Ga sputtering target of the present disclosure, since the main body portion does not contain a Ga phase, the melting and exudation of metallic Ga can be inhibited.

Therefore, it is considered that according to the Al-Sc-Ga sputtering target of the present disclosure, even when it is bonded to a backing plate via a bonding material interposed therebetween, the formation of a low-melting-point alloy due to contact between exuded molten metallic Ga and the bonding material is inhibited, thus making it possible to inhibit the detachment of the main body portion caused by the melting of the low-melting-point alloy.

### (Film Deposition by Sputtering)

The main body portion obtained in each example was bonded to a backing plate made of copper with a bonding material made of indium interposed therebetween to provide a sputtering target. When a film deposition test was performed using this target under the following conditions, an Al-Sc-Ga-N film having a thickness of 800 nm was provided without detachment or the like between the main body portion and the backing plate. The ratio of Al, Sc, and Ga in the thin film (Al:Sc:Ga) may be considered to be the same as the ratio of Al, Sc, and Ga in the main body (Al:Sc:Ga).

The proportion of nitrogen contained in the Al-Sc-Ga-N film is not particularly limited. For example, the proportion of the number of nitrogen atoms based on the total number of Al, Sc, Ga, and N atoms may be 20% or more, 30% or more, or 40% or more, and may be 70% or less, 60% or less, or 50% or less. Furthermore, the proportion may be 20% or more and 70% or less, 30% or more and 60% or less, or 40% or more and 50% or less.

### <Conditions>

Apparatus used: CMS-6400 Combinatorial Sputtering System
Film deposition method: magnetron sputtering method
Base pressure: 1.0 × 10⁻⁵ Pa
Sputtering gas: Ar + 25% N₂
Sputtering pressure: 0.3 Pa
Substrate: silicon
Lower electrode layer: molybdenum (thickness: 200 nm)
Upper electrode layer: molybdenum (thickness: 100 nm)
Film deposition temperature: 500°C
Power: RF 200 W

### (Structural Analysis of Thin Film)

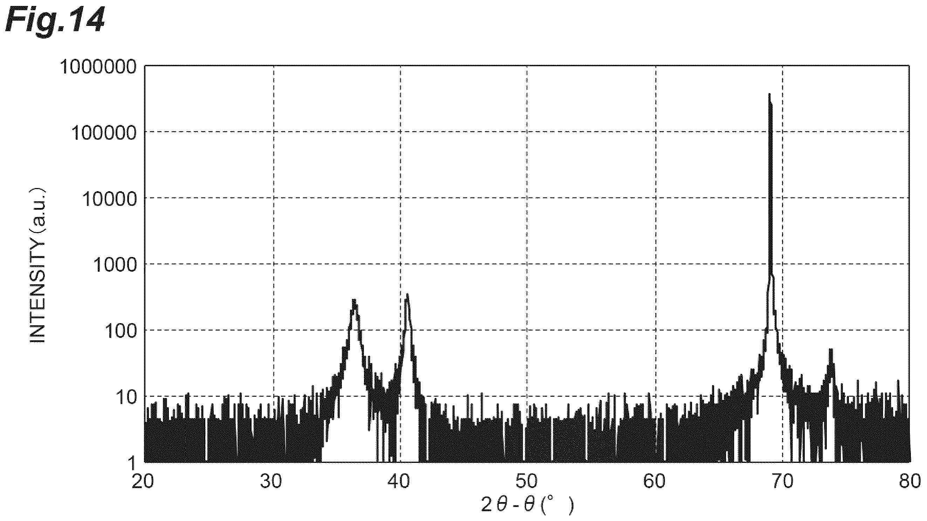

For the Al-Sc-Ga-N film obtained in Example 6, a structural evaluation was performed by measuring its X-ray diffraction peak pattern under the following conditions with an X-ray diffractometer (manufactured by Bruker AXS, D8 DISCOVER). The measured X-ray diffraction peak pattern is illustrated in Fig. 14. The results in Fig. 14 revealed that the resulting Al-Sc-Ga-N film was a single layer with a hexagonal wurtzite-type structure.

### <Conditions>

Radiation source: CuKα radiation
Monochromator: Ge(220)
Pathfinder: Crystal3B
Measurement mode: 2θ-θ scan
Step Size: 0.02°
Scan Speed: 4 °/min
Scan range: 20° to 80°

### (Evaluation of Piezoelectric Properties)

The piezoelectric properties of the resulting Al-Sc-Ga-N film were evaluated with a piezoelectric wafer evaluation system d₃₃ meter (manufactured by Lead Techno Co., Ltd.) under the following conditions. The piezoelectric coefficient d₃₃ was 53 pC/N.

### <Conditions>

Measurement temperature: room temperature
Upper electrode diameter: ø1 mm
Probe diameter: 60 µm
Number of measurements: 50 times

The present application is based on Japanese Patent Application (Japanese Patent Application No. 2023-039496) filed on March 14, 2023, which is incorporated herein by reference in its entirety. All references cited herein are incorporated in their entirety.

### Industrial Applicability

The Al-Sc-Ga sputtering target of the present disclosure can be used as a sputtering target for forming an AlScGaN film used in, for example, memory elements, such as ferroelectric memories, and piezoelectric elements, such as pressure sensors and vibration sensors.

### Reference Signs List

| | | | | |
|---|---|---|---|---|
| 10 | main body portion, | 20 | backing plate, | |
| 30 | bonding material, | 100 | Al-Sc-Ga sputtering target | |

## Claims

1. An Al-Sc-Ga sputtering target, comprising a main body portion, wherein the main body portion contains Al, Sc, and Ga and does not contain a Ga phase.

2. The Al-Sc-Ga sputtering target according to claim 1, wherein an atomic ratio of Sc to Al (Sc/Al) in the main body portion is 0.25 or more.

3. The Al-Sc-Ga sputtering target according to claim 1 or 2, wherein an atomic ratio of Sc to Ga (Sc/Ga) in the main body portion is 0.5 or more.

4. The Al-Sc-Ga sputtering target according to any one of claims 1 to 3, wherein an atomic ratio of Sc to Ga (Sc/Ga) in the main body portion is 20 or less.

5. The Al-Sc-Ga sputtering target according to any one of claims 1 to 4, further comprising a backing plate bonded to the main body portion with a bonding material interposed therebetween.

6. A method for producing an Al-Sc-Ga sputtering target, comprising a first step of producing a main body portion containing Al, Sc, and Ga in such a manner that the main body portion does not contain a Ga phase.

7. The method for producing an Al-Sc-Ga sputtering target according to claim 6, wherein the main body portion is produced in the first step in such a manner that an atomic ratio of Sc to Al (Sc/Al) is 0.25 or more.

8. The method for producing an Al-Sc-Ga sputtering target according to claim 6 or 7, wherein the main body portion is produced in the first step in such a manner that an atomic ratio of Sc to Ga (Sc/Ga) is 0.5 or more.

9. The method for producing an Al-Sc-Ga sputtering target according to any one of claims 6 to 8, wherein the main body portion is produced in the first step in such a manner that an atomic ratio of Sc to Ga (Sc/Ga) is 20 or less.

10. The method for producing an Al-Sc-Ga sputtering target according to any one of claims 6 to 9, further comprising a second step of bonding a backing plate to the main body portion with a bonding material interposed therebetween.
